Europäisches Patentamt

European Patent Office

Office européen des brevets

(11) Publication number: **0 436 089 A2**

## EUROPEAN PATENT APPLICATION

(21) Application number: **90121592.1**

(51) Int. Cl.5: **G11C 11/56**

(22) Date of filing: **12.11.90**

(30) Priority: **19.12.89 US 452884**

(43) Date of publication of application:
**10.07.91 Bulletin 91/28**

(84) Designated Contracting States:
**DE FR GB**

(71) Applicant: **International Business Machines Corporation**
**Old Orchard Road**
**Armonk, N.Y. 10504(US)**

(72) Inventor: **Kiehl, Richard Arthur**
**1418 Riverbank Road**
**Stamford, Connecticut 06903(US)**

(74) Representative: **Klocke, Peter, Dipl.-Ing.**
**IBM Deutschland GmbH Patentwesen und**
**Urheberrecht Schönaicher Strasse 220**
**W-7030 Böblingen(DE)**

(54) **Superlattice multistate circuits.**

(57) Several types of superlattice multistate circuits are disclosed, including a basic building block multistate inverter circuit which can be utilized in multistate memory circuits or in multistate combinatorial or sequential logic circuits. The multistate inverter circuit comprises a superlattice transistor (Q0) having a staircase drain current versus gate voltage characteristic in series with an inverter load. In a particular embodiment, an improved erasable memory is formed by multiple memory cells, wherein each memory cell comprises a pair of cross coupled inverter circuits having a multiple number, greater than two, of stable memory states. The superlattice transistors can be driven, by the application of an appropriate drive voltage potential, to assume any one of the multiple number of stable states. In a particular exemplary embodiment disclosed herein, the superlattice transistors can be driven to any one of four stable states, and thus form a two bit memory.

FIG.6

Xerox Copy Centre

## SUPERLATTICE MULTISTATE CIRCUITS

The present invention relates generally to superlattice multistate circuits, and more particularly pertains to a basic building block multistate inverter circuit which can be utilized in multistate memory circuits or in multistate logic circuits. The multistate inverter circuit comprises a superlattice transistor having a staircase drain current versus gate voltage characteristic in series with an inverter load. In a particular embodiment, an improved erasable memory is formed by multiple memory cells, wherein each memory cell comprises a pair of cross coupled inverter circuits having more than two stable memory states, with each inverter having a superlattice field effect transistor therein.

Conventional erasable semiconductor memory cells are based upon a latch circuit which includes a pair of cross-coupled inverter transistors which latch (or lock) in either of two stable states. The two states (0,1) of the memory cell are simply the stable logic states of the inverter, which are determined by the inverter transfer function thereof.

The present invention is particularly described herein with respect to a Field Effect Transistor (FET), although the teachings herein have applicability to other types of transistors and semiconductors. Field effect transistors are commonly single layer devices in which charge carriers flow from a source to a drain under control of a gate, and the source, gate and drain each typically have a metallic contact electrode. The gate may include a Schottky barrier that creates a depletion layer to control the transfer of charges flowing beneath the gate from the source to the drain.

Recent developments in semiconductors have produced multilayer heterojunction devices. These devices are typically fashioned from alternate layers of gallium arsenide (GaAs) and aluminum gallium arsenide (AlGaAs). Under voltages suitably applied to such a device, a high concentration of high mobility electrons can be formed in the GaAs layer at the junction of the materials. This region is termed a 2 Dimensional Electron Gas (2DEG). Electrons in the 2DEG have a very high mobility and high concentration, which results in transistors having a switching speed almost four times as fast as other transistors.

In high mobility devices such as field effect transistors, it is known to place a source and drain contact on a common upper surface. A Schottky barrier, as a gate, is positioned between the source and drain on the common upper surface. The gate controls the flow of charges in the 2DEG beneath the gate electrode, see for example U.S. Patent Nos. 4,558,337; 4,471,367 and 4,455,564. In these devices, the source and drain contacts extend only to the upper conducting layer.

Another approach in the prior art is to fabricate the transistor having the base region formed from a superlattice. As shown in U.S. Patent 4,137,542, the superlattice can be formed with alternate layers of different materials, such as GaAs and GaAlAs. Another example of a superlattice is disclosed in Surface Science No. 113, pp. 479-480, (1982), which discloses a periodic sequence of n and p doped GaAs layers with intrinsic layers therebetween. Japanese Patent 58-114455 discloses a superlattice base formed of alternate layers of p+ doped GaAsSb and p- doped GaInAs sandwiched between emitter and collector layers of n doped GaInAs. Moreover, a heterostructure superlattice field effect transistor similar to that disclosed herein is disclosed by U.S. Patent 4,424,525. However, one major distinction of the present invention relative to many of these prior art devices having alternating layers of GaAs and GaAlAs is that in the prior art devices only the GaAs layers have charge carriers, not the GaAlAs layers, such that the staircase drain current versus gate voltage characteristic of the present invention is not obtained thereby during normal operation.

The concept of connecting several two state devices together to provide a multistate output is also known in the prior art. For example, connecting field effect devices having increasing threshold voltages in a memory cell will provide a multistate output. A second example is a prior art discrete multistate circuit with a staircase transfer characteristic, as illustrated in "Electronic Implementation of Multivalued Logic Networks", Appl. Phys. Lett., vol. 33, no. 7, pp. 665-667, (1978).

Accordingly, it is a primary object of the present invention to provide superlattice multistate circuits formed with a basic building block multistate inverter circuit comprising an inverter load in series with a superlattice transistor having a staircase drain current versus gate voltage characteristic. The multistate inverter is a basic building block type of circuit which can be employed in many different types of circuits such as in combinatorial or sequential logic circuits or in erasable memory circuits.

A further object of the subject invention is the provision of an improved erasable multistate memory providing a higher density data storage capacity in each multistate memory cell so that multiple bits (words) of data can be stored in each memory cell. In general, n bits of information can be stored in a cell that exhibits $2^n$ stable states.

Each memory cell is formed by a pair of cross coupled inverter circuits, each having a superlattice transistor, such that a multiple number, greater than two, of stable memory states is provided thereby. The superlattice transistor inverter can replace the cross coupled transistor inverters of a conventional memory cell, and the multistate cross coupled inverters can be driven, by the application of an appropriate drive voltage potential, to assume any one of the multiple number of stable states. In a particular exemplary embodiment disclosed herein, the cross coupled superlattice transistors can be driven to any one of four stable memory states, and thus form a two bit memory. Depending upon the number of layers in the superlattice, cross coupled inverter circuits formed by a superlattice transistor can be designed, within practical limitations, to be driven to any number of states such as eight stable states, and thus form a three bit memory, or be driven to any one of sixteen stable states, and thus form a four bit memory, etc.

In accordance with the teachings herein, the present invention as claimed provides a basic multistate inverter circuit comprising an inverter load in series with a superlattice transistor having a staircase drain current versus gate voltage characteristic. The transistor includes a multilayer channel structure that permits current to selectively pass through different layers of the device, formed by a plurality of super-imposed alternating layers of high $\sigma$ conductivity semiconductor material, wherein the maximum concentration of mobile carriers is high and the carrier mobility is high, and low $\sigma$ conductivity semiconductor material, wherein the maximum concentration of mobile carriers is low or the carrier mobility is low. The high $\sigma$ layers are current conducting layers, which are separated from each other by a low $\sigma$ relatively nonconducting layer. Each of the conducting layers defines an independent current path, thereby providing at least two independent current paths, and a carrier depletion control means controls the depletion of charge carriers in the conducting and the relatively nonconducting layers to selectively control the flow of current through the conducting layers in a staircase characteristic manner. Maximum concentration is the concentration that can be reached when the gate is so biased as to allow carriers into that layer, otherwise the layer is depleted of carriers. The concentration that can be reached in each layer depends upon not only the properties of the material of that layer, but also i) the arrangement of the layers in the structure (e.g., whether or not there is doping in the adjacent layers, as in the 2DEG case) and ii) the bias conditions. The conductivity of the layers at an applied drain voltage determines the increase in drain current in proportion to an increase in gate voltage. In different embodiments of superlattice structures, the carriers could be electrons or holes or both, and in some embodiments different layers may have different types of carriers. Each transistor is preferably a field effect transistor having a source and a drain on opposite sides of the multilayer channel.

Conductivity is the product of mobility $\mu$ and mobile carrier concentration, and depends upon gate bias conditions, in contrast to mobility $\mu$ which is a materials property and is therefore independent of bias conditions, etc.

In a preferred embodiment, the multilayer channel structure includes a plurality of superimposed alternating layers of high $\sigma$ and low $\sigma$ semiconductor material disposed on a substrate essentially parallel to an exposed surface. Source and drain electrode regions extend from the exposed surface through the plurality of layers to electrically contact each of the high $\sigma$ conducting layers and each of the low $\sigma$ layers. A carrier depletion or accumulation control means is disposed on the exposed surface between the first and second surface contacts, and is operable to sequentially enable the presence of charge carriers in the conducting and relatively nonconducting layers. The carrier depletion control means is thereby utilized to selectively control the flow of current through the conducting layers from the source to the drain electrode. The carrier depletion control means may be in the form of a Schottky barrier electrode deposited on the surface of the device. In an illustrated normally off embodiment, with no bias voltage applied to the Schottky electrode, no current flows between the source and drain electrodes. A small bias voltage can then be applied to the Schottky electrode sufficient to disable the depletion of charge carriers in the lowermost conducting layer beneath the Schottky gate electrode, resulting in current flowing in the lowermost conducting layer. With an increase in the potential applied to the Schottky gate electrode, current will also flow through the next lowermost undepleted conducting layer, and in a like manner current will also flow through additional undepleted conducting layers.

An alternative normally on embodiment of the multilayer gate structure could be designed with appropriate materials and doping levels to operate in a normally on manner with no bias voltage applied to the gate electrode, and with an increased bias voltage providing for the progressive depletion of charge carriers in the conducting and relatively nonconducting layers therebelow.

The foregoing objects and advantages of the present invention for superlattice multistate circuits may be more readily understood by one skilled in the art with reference being had to the following detailed description of several preferred embodiments thereof, taken in conjunction with the accompanying drawings wherein like elements are designated by identical reference numerals throughout the several view, and in which:

Figure 1    illustrates a conventional prior art erasable memory cell formed by a pair of cross coupled inverters;

Figure 2    shows the transfer characteristic curve for a conventional prior art erasable memory cell as illustrated in Figure 1;

Figure 3    illustrates a conceptual transfer characteristic curve which can form a basis for a multistate logic circuit or a multistate memory cell having four stable states, such as illustrated in Figure 6;

Figure 4    illustrates a multistate inverter circuit pursuant to the present invention which can be used in many different multistate logic or memory circuits;

Figure 5    is a characteristic curve for the transistor of Figure 6, illustrating the stepped nature of the drain current $I_D$ as the gate voltage $V_{GS}$ is increased; and

Figure 6    illustrates the structure of a heterostructure superlattice field effect transistor which can be utilized to form a multistate logic circuit or a multistate memory cell.

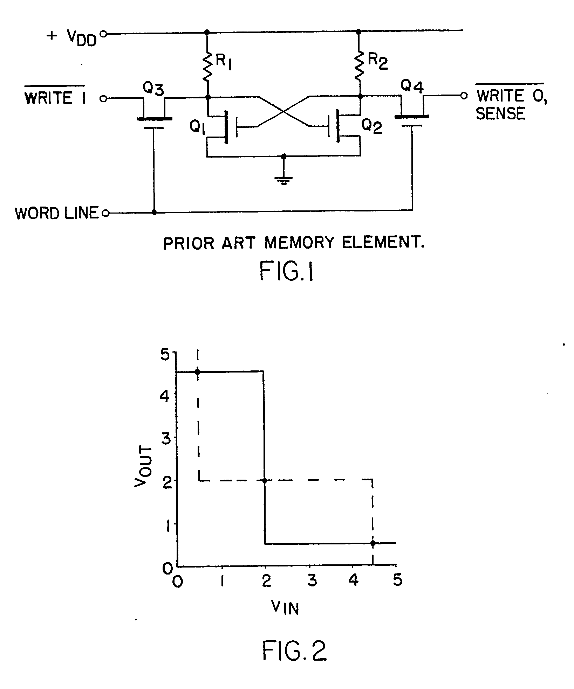

Figure 1 illustrates a typical prior art memory latch circuit comprising a pair of cross coupled inverters Q1-R1 and Q2-R2 which form a conventional erasable semiconductor memory cell. In this circuit, transistors Q3 and Q4 are pass transistors which function as on/off switches to respectively enable writing a data bit (0 or 1) into the memory element or reading the state (0 or 1) of the memory element. Resistors R1 and R2 are current supplying or load resistors connected between $V_{DD}$ and the cross coupled inverter transistors Q1 and Q2, and conceptually the resistors R1 and R2 could be replaced by equivalent current supplying transistors.

The cross coupled inverters Q1-R1 and Q2-R2 can latch in either of two stable states (0 or 1), which are stable logic states determined by the inverter transfer function illustrated in Figure 2. Figure 2 shows the solid line transfer function and its dashed line reflection, which determine the two stable states (solid circles) and the unstable state (open circle). The two stable states at Vout = 4.5V, Vin = 0.5V, and also at Vout = 0.5V, Vin = 4.5V, can store in a stable manner one bit of data. The memory cell can be driven to either stable state by applying a drive potential through either pass transistor Q3 (Write 1) or pass transistor Q4 (Write 0), and after the drive potential is removed the memory cell remains in its stable state, and can be read by sampling the potential through either pass transistor Q3 or Q4.

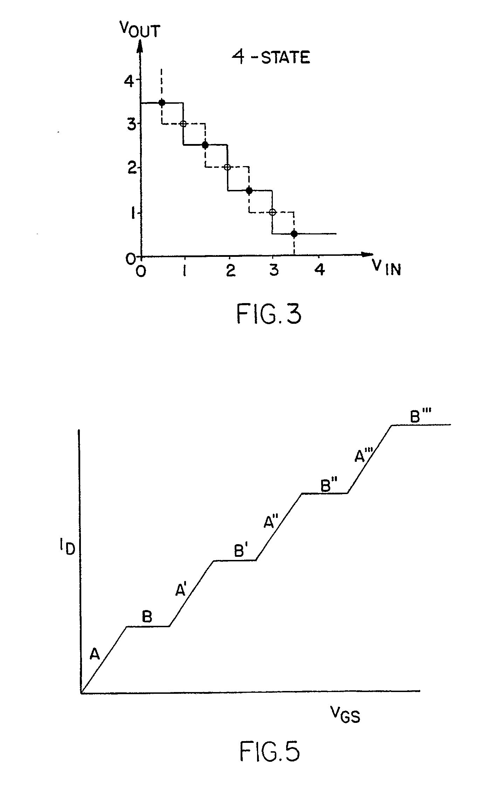

Figure 3 illustrates a conceptual transfer characteristic curve for a device having four stable states, indicated by the solid circles at Vout = 3.5V, Vin = .5V; Vout = 2.5V, Vin = 1.5V; Vout = 1.5V, Vin = 2.5V, and Vout = .5V, Vin = 3.5V, which can form a basis for multistate circuits (logic or memory) as taught herein.

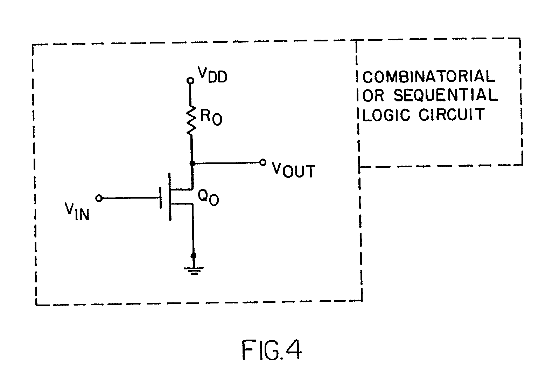

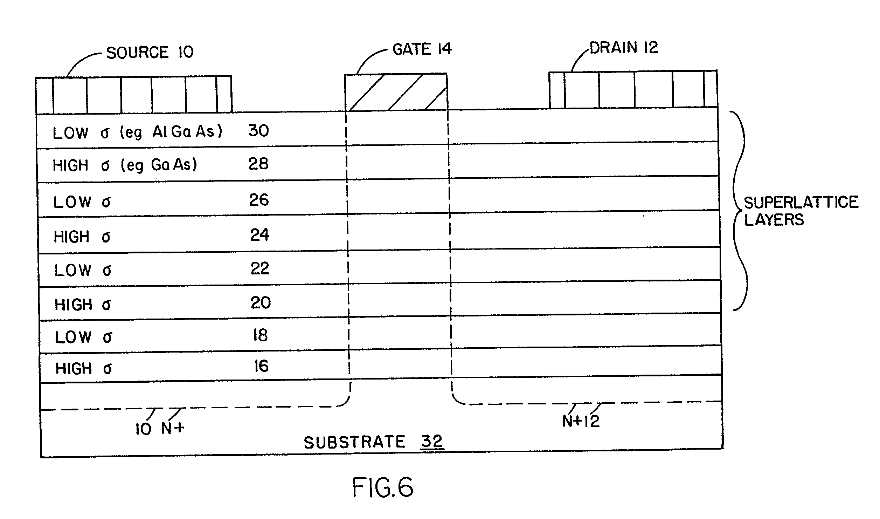

Figure 4 illustrates a multistate inverter circuit pursuant to the present invention which can be used in many different multistate logic circuits. The transistor Q0 is a superlattice multistate transistor such as shown in Figure 6 herein, and has a staircase drain current versus gate voltage characteristics as shown in Figure 5. In this circuit, the load resistor Ro can be replaced by a suitable load transistor. An inverter circuit as shown in Figure 4 is a basic element of an erasable memory circuit and also of many different types of combinatorial or sequential logic circuits, and could be utilized in such logic circuits in a manner as disclosed and taught by ELECTRONIC IMPLEMENTATION OF MULTI-VALUED LOGIC NETWORKS, Vranesic, et al., 1974 International Symposium on Multiple-Valued Logic, Morgantown, W.Va.

The inverter circuit of Figure 4 can replace each of the cross coupled inverter circuits Q1-R1 and Q2-R2 of Figure 1, and can be driven, by the application of an appropriate drive voltage potential, to assume any one of a multiple number of stable states. In the particular exemplary embodiment of a memory circuit disclosed herein, the cross coupled inverter circuits with the superlattice transistor can be driven to any one of four stable states, and thus form a two bit memory. A superlattice semiconductor could be designed, within practical limitations, with more or less layers in the superlattice structure to be driven to any number of stable states, such as three stable states in a ternary memory, or to eight stable states, and thus form a three bit memory, or be driven to any one of sixteen stable states, and thus form a four bit memory, etc.

The heterostructure superlattice structure of Figure 6 provides an FET with a staircase drain-current versus gate-voltage characteristic, and comprises a source 10 of n+ doped material having a surface contact electrode, and a drain 12 of n+ doped material having a surface contact electrode, separated by a gate 14 having a surface contact electrode and formed of a multilayered superlattice structure fabricated with layers of low σ conductivity material such as n doped AlGaAs with interposed layers of high σ material such as undoped GaAs. Referring to Figure 6, plural n doped AlGaAs layers 18, 22, 26 and 30 and plural undoped GaAs layers 16, 20, 24 and 28 are grown one upon the other on a GaAs substrate 32 which is a semi-insulator. The AlGaAs layers and the GaAs layers are subsequently doped n + as shown to form the source and drain electrode regions. The selected materials and doping levels of the gate structure of Figure 4 are selected to provide a normally off embodiment, such that with no bias voltage applied to the Schottky electrode, no current flows between the source and drain electrodes. A small bias voltage can then be applied to the Schottky gate electrode sufficient to disable the depletion of charge carriers in the lowermost conducting layer 16 beneath the Schottky gate electrode, resulting in current flowing in the lowermost conducting layer. With an increase in the potential applied to the Schottky gate electrode, some current may flow in the relatively nonconducting layer 18, but not much, however as the potential applied to the gate is increased further, a significant current will also flow through the next lowermost undepleted conducting layer 20, and in a like manner current will also flow through additional undepleted conducting layers 24 and 28, providing a staircase characteristic curve as illustrated in Figure 5.

An alternative normally on embodiment of the multilayer gate structure could be designed with appropriate materials and doping levels to operate in a normally on manner with no bias voltage applied to the gate electrode, and with an increased bias voltage providing for the progressive depletion of charge carriers in successively deeper layers of the high $\sigma$ and low $\sigma$ layers therebelow.

The Schottky gate electrode 14 is provided between the source 10 and the drain 12 surface electrode contacts, and for an enhancement mode, an increasingly larger gate-source voltage $V_{GS}$ causes increasingly shallower regions of the multilayer gate to be involved with conduction. In the structure of Figure 6, the alternating superlattice layers of high $\sigma$ GaAs semiconductor material, and of low $\sigma$ GlAlAs semiconductor material can be approximately 10 nm thick: The low $\sigma$ GaAlAs semiconductor material has low carrier mobility because of its aluminum content and because of its impurity scattering, has a low concentration of mobile carriers because of carrier trapping, although its carrier concentration is high, and is, therefore, a relatively poor carrier of current. The high $\sigma$ GaAs semiconductor material does not contain aluminum, does not have impurity scattering, has a high concentration of mobile carriers because of the formation of a 2DEG, and is, therefore, a relatively good conductor of current.

The doping levels and structure of Figure 6 are selected such that the device is normally off with zero bias voltage on the gate electrode, and all carriers are depleted in all of the high and low $\sigma$ layers 16 through 30. As illustrated in Figure 5, when a small positive voltage $V_{GS}$ is applied to the gate, carriers present in the lowermost high $\sigma$ layer 16 provide a drain current $I_D$ as shown by the lowermost portion A of the curve. Increasing the gate potential further causes the undepleted carrier region to progressively include the lowermost low $\sigma$ layer 18. However, the low $\sigma$ mobility layer 18 does not contribute much to the drain current $I_D$, which remains relatively constant through portion B of the curve. Increasing the gate potential further causes the undepleted carrier region to progressively include the second lowermost high $\sigma$ layer 20, to provide a progressively increasing current as shown by the portion A' of the curve. Increasing the gate potential further causes the undepleted carrier region to progressively include the second lowermost low $\sigma$ layer 22. However, the low conductivity layer 22 does not contribute significantly to the drain current $I_D$, which remains relatively constant through portion B' of the curves. In this manner, the drain current $I_D$ gradually increases as the gate potential is increased to progressively include further high $\sigma$ layers, and the drain current remains flat as the gate potential is increased to progressively include further low $\sigma$ layers, resulting in the curve of Figure 5.

The heterostructure superlattice structure thus has four stable states of operation (voltage values), and can be utilized in cross coupled inverters to form a stable memory by latching in any one of the four stable states, as illustrated by the transfer characteristic curve of Figure 3.

The transistors utilized in the present invention may be fabricated with any semiconductor material such as silicon, germanium, or gallium arsenide. A transistor with different doped layers of the same material could also be utilized rather than a heterojunction structure. The thickness of each pair of doped and undoped layers, referred to as the period of the superlattice, can be chosen in dependence upon the application.

## Claims

1. An inverter circuit comprising an inverter load ($R_o$) in series with a superlattice transistor ($Q_0$) having a staircase drain current versus gate voltage characteristic, wherein the transistor includes a multilayer channel structure that permits current to selectively pass through different layers of the device, said multilayer channel structure including a plurality of superimposed alternating layers of high $\sigma$ conductivity semiconductor material (16, 20, 24, 28) and low $\sigma$ conductivity semiconductor material (18, 22, 26, 30), with the high $\sigma$ layers containing charge carriers and being current conducting layers, which are separated from each other by a low $\sigma$ conductivity layer also containing charge carriers but of low $\sigma$ conductivity to result in a relatively nonconducting layer, such that each of the conducting layers defines an independent current path, thereby providing at least two independent current paths, and a carrier depletion control means controlling the depletion of charge carriers in the conducting and nonconducting layers to selectively control the flow of current through the conducting layers in said staircase characteristic manner.

2. A circuit as claimed in claim 1, wherein said transistor is a heterostructure field effect transistor having a source (10) and a drain (12) on opposite sides of said channel.

3. A circuit as claimed in claim 1 or 2, in a high density erasable memory circuit comprising a plurality of memory cells, wherein each memory cell can store in memory more than one bit of information by latching in any one of more than two stable memory states, wherein each erasable memory cell comprises a pair of cross coupled inverter circuits as claimed to provide a multiple number, greater than two, of stable memory states, which can be driven, by the application of an appropriate drive voltage potential, to assume any one of the stable memory states.

4. A circuit as claimed in claims 1 - 3, wherein the multilayer channel structure comprises at least four alternating layers of high $\sigma$ and low $\sigma$ mobility semiconductor materials, such that the cross coupled inverter circuits can be driven to any one of four stable states, and thus form at least a two bit memory.

5. A circuit as claimed in claim 1 or 2, in a combinatorial logic circuit.

6. A circuit as claimed in claim 1 or 2, in a sequential logic circuit.

PRIOR ART MEMORY ELEMENT.

FIG.1

FIG.2

FIG.3

FIG.5

FIG.4

SUPERLATTICE LAYERS

DRAIN 12

GATE 14

SOURCE 10

LOW σ (eg AlGaAs) 30
HIGH σ (eg GaAs) 28
LOW σ 26
HIGH σ 24
LOW σ 22
HIGH σ 20
LOW σ 18
HIGH σ 16

10 N+

N+12

SUBSTRATE 32

FIG.6